# EUROPEAN PATENT SPECIFICATION

(11) **EP 0 293 461 B1**
(45) Date of publication and mention of the grant of the patent: **15.06.1994**
(21) Application number: 88900660.7
(22) Date of filing: 18.12.1987
(51) Int. Cl.: G03F 7/00, G03H 1/02, G03H 1/18

(54) **HOLOGRAMS**
HOLOGRAMME
HOLOGRAMMES

(30) Priority: 19.12.1986 US 944428
(43) Date of publication of application: 07.12.1988
(73) Proprietor: POLAROID CORPORATION, Cambridge, Massachusetts 02139 (US)
(72) Inventor: INGWALL, Richard, T., Newton, MA 02165 (US); TROLL, Mark, A., Somerville, MA 02143 (US)
(74) Representative: Smulders, Theodorus A.H.J., Ir.
(86) International application number: US8703403
(87) International publication number: WO8804796

(56) References cited:
- WO-A-81/01389
- GB-A- 2 113 868
- US-A- 3 601 017
- US-A- 3 672 744
- US-A- 3 776 727
- US-A- 4 201 441
- US-A- 4 535 041
- US-A- 4 588 664
- PATENT ABSTRACTS OF JAPAN, volume 10, no. 149 (P-461)(2206), 30 May 1986 ; & JP-A-612181
- PATENT ABSTRACTS OF JAPAN, volume 10, no. 53 (P-433)(2110), 4 March 1986, & JP-A-60198576
- PATENT ABSTRACTS OF JAPAN, volume 10, no. 132 (P-456)(2189), 16 May 1986, & JP-A-60254173
- PATENT ABSTRACTS OF JAPAN, volume 9, no. 182 (P-376)(1905), 27 July 1985, & JP-A-6052889
- RESEARCH DISCLOSURE, no. 108, April 1973, (Havant, Hampshire, GB), "Image forming elements and processing", pages 13-16, disclosure no. 10804.

## Description

This invention is concerned with volume phase holograms and other holographic elements, and more particularly with the provision of volume phase holograms and other holographic elements characterized by having microscopic areas of a material having an index of refraction different from that of the holographic fringes. The novel holographic elements may exhibit increased diffraction efficiency and/or other desirable properties.

Volume phase holograms, i.e., refractive index modulated holograms, are well known and have been prepared from a variety of photosensitive materials, particularly ones in which the holographic fringes are formed by photopolymerization or cross-linking.

Dichromated gelatin (DCG) has been widely used for the formation of volume phase holograms. The mechanism by which the holographic image is formed in DCG, however, is not settled, and several mechanisms have been proposed. One such proposal is that "cracks" or "voids" are formed between fringe planes in the gelatin, and that the resulting difference between the index of refraction of air (in the cracks or voids) and that of gelatin gives increased index modulation. (See A. Graube, "Holographic Optical Element Materials Research", U.S. Air Force Office of Scientific Research Technical Report 78-1626 (1978), available from the U.S. Defense Technical Information Center as DTIC Technical Report ADAO62692, particularly pages 95-113.) The presence of "voids" is disputed in an earlier article (R.K. Curran and T.A. Shankoff, "The Mechanism of Hologram Formation in Dichromated Gelatin", Applied Optics, July, 1970, Vol. 9, pp. 1651-1657; particularly p. 1655), which concludes that "cracks" provide an air-gelatin interface. A 1980 publication (B.J. Chang, "Dichromated Gelatin Holograms and Their Applications", Optical Engineering, Vol. 19, pp. 642-648; see particularly pp. 642-643) proposes yet another mechanism: a "molecular-chain spring" model. Yet another mechanism--an interaction between isopropanol and gelatin causing cracks when the isopropanol is removed--is proposed by J.R. Magarinos and D.J. Coleman, "Holographic Mirrors", Optical Engineering, 1985, Vol. 24, pp. 769-780. These researchers recognized that one way to support the hypothesis of the presence of voids (microvoids) would be to demonstrate the loss of holographic efficiency by replacing air in such voids with a liquid having an index of refraction matching that of gelatin, but they differed as to whether they achieved such a result. It is clear, however, that these researchers were investigating mechanisms rather than ways to modify the optical properties.

A particularly useful photopolymerizable composition to form volume phase holograms is described and claimed in U.S. Patent No. 4,588,664 issued May 13, 1986 to Herbert L. Fielding and Richard T. Ingwall. These photopolymerizable compositions comprise a dye sensitizer such as methylene blue, a branched polyethylenimine as a polymerization initiator, and a free radical polymerizable ethylenic unsaturated monomer, preferably, e.g., an acrylic monomer, and lithium acrylate. A method of stabilizing holograms formed from this photopolymerizable composition is described and claimed in U.S. Patent No. 4,535,041 issued to Herbert L. Fielding and Richard T. Ingwall on August 13, 1985.

JP-A-2181/86 discloses a process for preparing a hologram from a photosensitive material. After holographic exposure the material is subjected to an extracting treatment with a solvent, e.g. ethanol, in order to remove crosslinking agent and sensitizer which are no longer needed. By the extracting treatment the occurrence of fine cracks, which would result in unsatisfactory diffraction efficiencies, is prevented.

The present invention relates to a volume phase holographic element containing holographic information in the form of a pattern of fringes separated by a matrix material, the fringes having a different composition than the matrix material, said holographic element being characterized in that it comprises microvoids in the matrix material, said microvoids being at least partially filled with a material other than air and which material differs by at least 0.1 in its index of refraction from that of the matrix material.

As is well known and understood in the holographic art, volume phase holograms record information as a modulation of the refractive index of the medium in which the recording is effected. Thus, the polymerization of a monomer present in a photopolymerizable film records the laser holographic exposure as a pattern of "fringes" or "strata" of polymer. The fringes are relatively parallel to the support in a volume phase reflection hologram, and relatively perpendicular to the support in a volume phase transmission hologram. The polymer comprising the fringes has a different index of refraction than the matrix material present between the fringes, and the resulting modulation of light as a function of the index differences permits reconstruction of the hologram.

Examination by light microscopy and scanning electron microscopy of the microstructure of holograms formed using the photopolymerizable compositions described in the above-referenced U.S. Patent No. 4,588,664 has revealed the presence of microvoids containing air in the matrix material positioned between the photopolymer fringes; the microvoids were generally spherical in cross-section. Although they appear isolated in the electron micrographs, the microvoids are interconnected. Alternating planes of solid and porous (connected microvoids) material appear in layers spaced according to the appropriate Bragg condition. The microvoids generally have a diameter on the order of about 50-80% of the distance between adjacent solid phases (fringes), and may have a diameter, for example, on the order of about half the wavelength of the light reflected by a holographic reflection optical element. These microvoids contain air and they vary in concentration as a function of the intensity of the exposure. It is believed that these microvoids result, at least in part, from the lateral diffusion of monomer within the film to areas where polymerization is occurring. Development and drying of the photopolymerized film removes water or other solvent for the monomer, and air fills the resulting microvoids. Since the air-filled microvoids have some light-scattering power, the holographic element may exhibit some haze as a function of the size of the microvoids.

It now has been found that it is possible to replace at least part of the air in the microvoids with another material without significantly changing the relative spacing of the holographic fringes. The added material preferably is permanently retained within the holographic element. Desirable changes in the optical properties/holographic performance may be effected in this manner, since small differences between the refractive index or optical density of the photopolymerized (fringe) areas and that of the added material are amplified in their effect on the optical properties of the combination. For convenience, the material replacing air in the microvoids may be referred to as the "microvoid material".

The material replacing the air in the microvoids is introduced by imbibing the desired material, or a solution thereof, into the holographic element, e.g., by dipping. The added material may be one capable of further reaction, e.g., a polymerizable monomer or a cross-linkable compound, and such further reaction is effective to permanently incorporate said material within the holographic element. Incorporation of a polymerizable monomer may be effected simultaneously with a polymerizable initiator, or more preferably the initiator may be introduced first followed by the polymerisable monomer. The selection of the initiator and of the monomer should avoid the introduction or formation of any undesirable coloration. Particularly useful monomers for the purpose of obtaining a lower index polymer in the microvoids are fluorinated, particularly perfluorinated monomers. Polymerization may be effected by any known method, e.g., ultraviolet initiation, suitable for the monomer and compatible with the hologram matrix material. In certain instances, a thin film of the resulting polymer may also be formed on the surface of the hologram, and such a polymeric film may provide added physical protection, e.g., resistance to moisture or other environmental factors which otherwise would adversely affect the stability or optical properties of the hologram. In addition, such a surface polymeric film may be utilized to adhere or bond the hologram to another material or hologram.

The microvoid material may be a dye or other light-absorbing compound, thus providing absorption of light of a predetermined wavelength or wavelength band. This embodiment is particularly useful in the provision of holographic notch filters, e.g., to provide eye protection against lasers, since the resulting optical density (transmission) will be a combination of the laser light reflected and the laser light absorbed. By suitable selection of the added light absorber, one may increase the optical density with respect to the wavelength(s) of concern while maintaining substantial transmission of other wavelengths, thus permitting increased protection for the user without undesirable or excessive loss of vision in, e.g., visible light.

The added material may provide a reduction in the haze level of the holographic element by virtue of the difference in index of refraction between it and the "fringe" polymer being less than the difference between the fringe polymer and air. While in some instances there may be a reduction in diffraction efficiency as a result, particularly if the hologram is a reflection hologram, the benefit of reduced haze may more than offset the reduction in diffraction efficiency. Indeed, if the added material has an index of refraction that nearly matches that of the fringe polymer in one region of the spectrum, e.g., the visible, but differs in another region, e.g., the infrared, one may essentially eliminate haze in the first region while obtaining strong reflectivity in the other region.

Selection of suitable materials to fill the microvoids may be done by selecting materials of the desired index, followed by routine testing to determine permeability of the hologram to the test material. It will be recognized that suitable combinations of microvoid material and of hologram matrix may differ as a function of changes in either component. A microvoid material is utilized which differs by at least 0.1 in its index of refraction from that of the hologram matrix, with greater effects being obtained where the index difference is greater. By selecting microvoid materials and solvents which do not swell the matrix, or swell it very little, the spacing between fringes may be maintained substantially unchanged; conversely, one may increase the spacing between recorded fringe planes by selecting microvoid materials and solvents which swell the matrix.

Since the average refractive index of the microvoid filled film is higher than that of the film with air filled microvoids, the wavelength of maximum reflectivity for reflection holograms is shifted towards longer wavelengths, i.e., towards the red, accompanied by a reduction in diffraction efficiency. This property may be used to adjust the wavelength of maximum reflectivity in narrow band holographic filters, since it is possible to make predictive adjustments of the peak wavelength over a range of about 50-100 nm as a function of the index of refraction of the material selected to fill the microvoids.

In the case of transmission holograms, the peak angle of diffraction is shifted by the presence of the microvoid material. Since the efficiency of such gratings varies periodically with grating strength (which varies with exposure level), the microvoid material may either increase or lower the diffraction efficiency of the grating.

If the microvoid material has optical activity, i.e., it exhibits a different index of refraction for right- and left-circularly polarized light, the resulting hologram will exhibit different properties for light of the two polarizations. If, for example, the microvoid material in a reflection hologram has substantially the same refractive index for one polarization of light as the matrix, that type of circularly polarized light would be transmitted with little or no attenuation, while light of the opposite polarization would be strongly reflected. A transmission hologram incorporating such a microvoid material would diffract the two types of circularly polarized light to different angles.

It will be recognized that the physical size of the material incorporated in the microvoids must be small enough to enter into the microvoids, and that this size will vary with the size of the microvoids.

The microvoid material may be selected to increase the environmental stability of the hologram, e.g., to humidity and/or temperature, or to reduce or eliminate adverse effects as the result of contact with adhesives or plasticizers. (The stabilization treatment comprising sequential treatment with a zirconium salt and a fatty acid described in the above-mentioned U.S. Patent No. 4,535,041 does not fill the microvoids, nor did the α-cyanoethyl acrylate glue used in Example 3 of the above-mentioned U.S. Patent No. 3,588,664.)

For convenience, the disclosures of the above-mentioned U.S. Patents Nos. 4,588,664 and 4,535,041 are hereby expressly incorporated herein.

The following examples are given for the purpose of illustration and are not intended to be limiting.

### Example 1

A transmission hologram was prepared using a photopolymerizable film of the type described in Example 7 of the above-mentioned U.S. Patent No. 4,588,664, following the general procedure for development and stabilization described in said example using helium-neon laser light (633 nm). The final, post-processing dry thickness of the film (exclusive of the support) was about 6 microns. Analysis of the transmission spectrum of the dry hologram using a visible spectrophotometer showed a spectral bandwith of about 170 nm and a maximum diffraction efficiency of 83% at 565 nm. When trifluoroethanol (refractive index 1.29) was imbibed into the dry hologram the spectral bandwith was reduced to about 60 nm, the maximum diffraction efficiency increased slightly to 87% and the wavelength of maximum efficiency was shifted to about 635 nm. The trifluoroethanol was washed out of the hologram with several applications of isopropanol and acetone, and the hologram dried. General Electric Silicone Oil SF 99 (refractive index 1.39) then was imbibed into the hologram; the diffraction efficiency was measured to be about 58% with the wavelength of maximum efficiency about 630 nm.

### Example 2

A small amount of a 1% solution of benzoin ethyl ether in xylene was placed on a transmission hologram prepared in the manner described in Example 1, and the xylene allowed to evaporate. A small quantity of a perfluoropolyether diacrylate 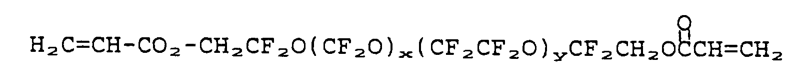
(molecular weight about 2100; refractive index 1.31) then was dropped on the holographic slide, allowed to spread over the holographic image area and then covered with a glass slide. The monomer impregnated hologram was exposed to ultraviolet light (405 nm) for 10 minutes, followed by a 10 minute exposure to 365 nm ultraviolet light. The cover glass was observed to be fixed in place after the first UV exposure. The diffraction efficiency after the second UV exposure was found to be about 20%, as compared with an initial efficiency of 74%. The cover glass was removed and the hologram boiled in water for about one and a half hours, after which the efficiency was found to be about 22%. The hologram was removed from its glass support as an intact but somewhat fragile free-standing film.

### Example 3

A mixture of a solution of diethoxyacetophenone dissolved in 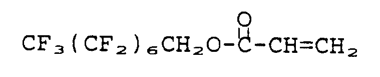
and of the perfluorinated monomer used in Example 2 was imbibed into a transmission hologram prepared in the manner described in Example 1 using a helium-neon laser exposure of 15 milliJoules/cm². The hologram then was exposed to ultraviolet light for 15 minutes. The diffraction efficiency of the treated hologram was found to be 70% as compared with the initial diffraction efficiency of 22%.

### Example 4

The procedure described in Example 2 was repeated using a reflection hologram exhibiting a diffraction efficiency greater than 99% at 490 nm and a twenty minute UV exposure. The diffraction efficiency of the resulting hologram containing the polymerized perfluorinated polymer in the microvoids was found to be 80% at 585 nm. After heating at 150°C for about 15 hours, the diffraction efficiency of the treated reflection hologram was found to be 87% at 540 nm.

### Example 5

A holographic mirror (reflection hologram) in the center of a photopolymerizable layer on a glass support, made using a helium-neon laser in the general manner described in Example 1, was treated with a solution of erythrosin in trifluoroethanol. After evaporation of the solvent, the photopolymerized layer was pink in color. The dye could not be removed by washing with isopropanol, methanol or mixtures of these alcohols with water. Spectrophotometric measurements of the optical density (transmission) were made at several angles of incidence. The dyed holographic mirror area exhibited a peak optical density greater than 5 for wavelengths between 530 and 555 nm at angles of incidence from 0 to 40°. By comparison, at normal incidence the original holographic mirror had a peak optical density of 2.8 at 580 nm, and the dyed non-holographic region had a peak optical density of 3.5 at 540 nm. The original holographic mirror was still visible by reflected light. Based upon these measurements, it was concluded that the erythrosin at least partially filled the microvoids.

It will be understood that other binders and polymers capable of providing volume phase holograms may be used in place of that used in the above example, provided that suitable microvoid materials may be imbibed into the hologram.

It will be understood that the holograms of this invention may be incorporated into other optical structures by the use of suitable adhesives, e.g., optical expoxy adhesives. In addition, the holograms may be potted or only the edges sealed to increase environmental stability.

## Claims

1. A volume phase holographic element containing holographic information in the form of a pattern of fringes separated by a matrix material, the fringes having a different composition than the matrix material, characterized in that the holographic element comprises microvoids in the matrix material, said microvoids being at least partially filled with a material other than air and which material differs by at least 0.1 in its index of refraction from that of the matrix material.

2. A volume phase holographic element as defined in claim 1, characterized in that the refractive index of the microvoid filling material is lower than that of the matrix material.

3. A volume phase holographic element as defined in claim 1, characterized in that said matrix comprises branched polyethyleneimine and said fringes comprise a polymerized ethylenic monomer.

4. A volume phase holographic element as defined in claim 1, characterized in that the microvoid filling material is hydrophobic.

5. A volume phase holographic element as defined in claim 2, characterized in that the microvoid filling material is a polymerized fluorinated monomer.

6. A method of forming a volume phase holographic element comprising effecting a holographic exposure of a photosensitive element to laser light and developing the exposed photosensitive element to provide a volume phase holographic element in the form of a pattern of fringes separated by a matrix material, characterized in that during development microvoids are formed in the matrix material between the fringes, and at least part of the air in said microvoids is replaced by a material which differs by at least 0.1 in its index of refraction from that of the matrix material.

7. The method as defined in claim 6, characterized in that that photosensitive element is a photopolymerizable element.

8. The method as defined in claim 6, characterized in that the photopolymerizable element comprises a dye sensitizer, branched polyethyleneimine, and a free radical polymerizable ethylenic unsaturated monomer.

9. The method as defined in claim 6, characterized in that a polymerizable monomer is introduced into said microvoids, and said monomer is then polymerized to provide said material having a different index of refraction.

## Patentansprüche

1. Volumen-Phasen-holographisches Element, enthaltend eine holographische Information in Form eines Musters von Streifen (fringes), die durch ein Matrixmaterial voneinander getrennt sind, wobei die Streifen eine andere Zusammensetzung als das Matrixmaterial haben, dadurch gekennzeichnet, daß das holographische Element Mikrohohlräume im Matrixmaterial enthält, wobei die Mikrohohlräume mindestens teilweise mit einem anderen Material als Luft gefüllt sind, dessen Brechungsindex sich um mindestens 0,1 von dem des Matrixmaterials unterscheidet.

2. Volumen-Phasen-holographisches Element nach Anspruch 1, dadurch gekennzeichnet, daß der Brechungsindex des die Mikrohohlräume ausfüllenden Materials niedriger als der des Matrixmaterials ist.

3. Volumen-Phasen-holographisches Element nach Anspruch 1, dadurch gekennzeichnet, daß die Matrix verzweigtes Polyethylenimin enthält und die Streifen ein polymerisiertes ethylenisches Monomer enthalten.

4. Volumen-Phasen-holographisches Element nach Anspruch 2, dadurch gekennzeichnet, daß das die Mikrohohlräume ausfüllende Material hydrophob ist.

5. Volumen-Phasen-holographisches Element nach Anspruch 1, dadurch gekennzeichnet, daß das die Mikrohohlräume ausfüllende Material ein polymerisiertes fluoriertes Monomer ist.

6. Verfahren zur Herstellung eines Volumen-Phasen-holographischen Elements, wobei eine holographische Belichtung eines lichtempfindlichen Elements mit Laserlicht erfolgt und das belichtete lichtempfindliche Element entwickelt wird, um ein Volumen-Phasen-holographischen Element in Form eines Musters von Streifen zu erzeugen, die durch ein Matrixmaterial voneinander getrennt sind, dadurch gekennzeichnet, daß während der Entwicklung im Matrixmaterial Mikrohohlräume zwischen den Streifen gebildet werden und daß mindestens ein Teil der Luft in den Mikrohohlräumen durch ein Material ersetzt wird, dessen Brechungsindex sich um mindestens 0,1 von dem des Matrixmaterials unterscheidet.

7. Verfahren nach Anspruch 6, dadurch gekennzeichnet, daß das lichtempfindliche Element ein photopolymerisierbares Element darstellt.

8. Verfahren nach Anspruch 6, dadurch gekennzeichnet, daß das photopolymerisierbare Element einen Farbstoff-Sensibilisator, verzweigtes Polyethylenimin und ein durch freie Radikale polymerisierbares ethylenisch ungesättigtes Monomer enthält.

9. Verfahren nach Anspruch 6, dadurch gekennzeichnet, daß das polymerisierbare Monomer in die Mikrohohlräume eingeführt wird und daß das Monomer dann polymerisiert wird, um das Material mit einem unterschiedlichen Brechungsindex zu erzeugen.

## Revendications

1. Elément à hologramme de phase en volume, contenant une information holographique sous forme d'un réseau de franges séparées par une matière de matrice, les franges ayant une composition différente de celle de la matière de matrice, caractérisé en ce que l'élément holographique comprend, dans la matière de matrice, des microcavités qui sont au moins partiellement remplies d'un matériau autre que l'air et dont l'indice de réfraction diffère d'au moins 0,1 de celui de la matière de matrice.

2. Elément à hologramme de phase en volume, conforme à la revendication 1, caractérisé en ce que l'indice de réfraction du matériau de remplissage des microcavités est inférieur à celui de ladite matrice.

3. Elément à hologramme de phase en volume, conforme à la revendication 1, caractérisé en ce que ladite matrice est constituée d'une poly(éthylène imine) ramifiée et en ce que les dites franges sont constituées d'un monomère éthylénique polymérisé.

4. Elément à hologramme de phase en volume, conforme à la revendication 1, caractérisé en ce que le matériau de remplissage des microcavités est hydrophobe.

5. Elément à hologramme de phase en volume, conforme à la revendication 2, caractérisé en ce que le matériau de remplissage des microcavités est un monomère fluoré polymérisé.

6. Procédé de formation d'un élément à hologramme de phase en volume, comprenant le fait de réaliser l'exposition holographique d'un élément photosensible à la lumière d'un faisceau laser, et le fait de développer l'élément photosensible exposé, pour obtenir un élément à hologramme de phase en volume, sous la forme d'un réseau de franges séparées par une matière de matrice, caractérisé en ce que, pendant le développement, des microcavités se forment dans la matière de matrice située entre les franges, et au moins une partie de l'air présent dans ces microcavités est remplacée par un matériau dont l'indice de réfraction diffère d'au moins 0,1 de celui de la matière de matrice.

7. Procédé conforme à la revendication 6, caractérisé en ce que l'élément photosensible est un élément photopolymérisable.

8. Procédé conforme à la revendication 6, caractérisé en ce que l'élément photopolymérisable comprend un colorant sensibilisateur, une poly(éthylène imine) ramifiée et un monomère à insaturation éthylénique et polymérisable par voie radicalaire.

9. Procédé conforme à la revendication 6, caractérisé en ce qu'on introduit un monomère polymérisable dans lesdites microcavités, et l'on fait ensuite polymériser ce monomère pour obtenir ledit matériau ayant un indice de réfraction différent.
